# EUROPEAN PATENT SPECIFICATION

(11) **EP 1 160 359 B1**
(45) Date of publication and mention of the grant of the patent: **17.10.2007**
(21) Application number: 01304344.3
(22) Date of filing: 16.05.2001
(51) Int. Cl.: C30B 15/08, C30B 15/00

(54) **Process and appparatus for producing an oxide single crystal**
Verfahren und Vorrichtung zur Herstellung eines Oxid-Einkristalles
Procédé et appareillage pour la production des monocristaux d'oxyde

(30) Priority: 17.05.2000 JP 2000144815
(43) Date of publication of application: 05.12.2001
(73) Proprietor: NGK INSULATORS, LTD., Nagoya-City, Aichi Pref. 467-8530 (JP)
(72) Inventor: Yokoyama, Toshihisa, NGK Insulators, Ltd., Nagoya City, Aichi Pref. (JP); Noda, Ken-Ichi, NGK Insulators, Ltd., Nagoya City, Aichi Pref. (JP); Imai, Katsuhiro, NGK Insulators, Ltd., Nagoya City, Aichi Pref. (JP); Imaeda, Minoru, NGK Insulators, Ltd., Nagoya City, Aichi Pref. (JP)
(74) Representative: Paget, Hugh Charles Edward

(56) References cited:
- EP-A- 0 733 728
- US-A- 4 216 186
- US-A- 4 367 200
- PATENT ABSTRACTS OF JAPAN vol. 011, no. 163 (C-424), 26 May 1987 (1987-05-26) & JP 61 291487 A (SUMITOMO ELECTRIC IND LTD), 22 December 1986 (1986-12-22)
- PATENT ABSTRACTS OF JAPAN vol. 009, no. 271 (C-311), 29 October 1985 (1985-10-29) & JP 60 118688 A (TOSHIBA KK), 26 June 1985 (1985-06-26)

## Description

### BACKGROUND OF THE INVENTION

### 1. Field of the invention

The present invention relates to a process and an apparatus for producing an oxide single crystal.

### 2. Description of the Related Art

A single crystal of lithium potassium niobate and a single crystal of lithium potassium niobate-lithium potassium tantalate solid solution have been noted especially as single crystals for blue light second harmonic generation (SHG) device for a semiconductor laser. The device can emit even the ultraviolet lights having the wavelengths of 390nm, thus the crystals can be suitable for wide applications such as optical disk memory, medicine and photochemical fields, and various optical measurements by using such short-wavelength lights. Since the above single crystals have a large electro-optic effect, they can be also applied to optical memory devices using their photorefractive effect.

However, for an application of a second harmonic generation device, for example, even a small fluctuation in the composition of the single crystal may affect the wavelength of the second harmonic wave generated by the device. Therefore, a specific range of the composition required for said single crystals is severe, and the fluctuation in the composition should be suppressed in a narrow range. However, since the composition consists of as many as three or four components, growing a single crystal at a high rate is generally extremely difficult to achieve, while controlling the proportions of the components to be constant.

In addition, for optical applications, especially for the second harmonic wave generation, a laser beam having a short wavelength of, for example, about 400nm needs to propagate in the single crystal at as high a power density as possible. Moreover, the photo deterioration has to be controlled to the minimum at the same time. In this way, since controlling the photo deterioration is essential, the single crystal has to possess good crystallinity for this purpose.

Moreover, lithium niobate and lithium potassium niobate can be substituted between cations, thus solid solution in which the cations are solid-solved is produced. Therefore, the composition of the melt needs to be controlled to grow a single crystal of a specific composition. From such a background, a double crucible method and a method of growing a crystal while feeding raw materials have been examined mainly for the CZ method and the TSSG method. For example, Kitamura et al. tried to grow a lithium niobate single crystal of a stoichiometric composition by combining an automatic powder feeder to a double crucible CZ method (J. Crystal Growth, 116 (1992), p.327). However, it was difficult to increase a crystal growth rate with these methods.

NGK Insulators, Ltd. suggested a µ pulling-down method for growing the above single crystal with a constant compositional proportions, for example, in JP-A-8-319191. In this method, a raw material, for example, comprising lithium potassium niobate is put into a platinum crucible and melted, and then the melt is pulled out downwardly gradually and continuously through a nozzle attached to the bottom of the crucible. The µ pulling-down method can grow a single crystal more rapidly than the CZ method or the TSSG method does. Moreover, the compositions of the melt and the grown single crystal can be controlled by growing the single crystal continuously while supplementing the raw materials for growing the single crystal to the raw material melting crucible.

US-A-4367200 describes a single crystal manufacturing device, in which a molten liquid in a crucible is continuously taken out through a nozzle part by the action of gravity. Temperature control means for heating the nozzle part is provided. It is stated that, to further increase the temperature gradient in the solid-liquid phase, it is also possible to employ a cooling liquid or like means for cooling the grown crystal.

JP-A-61-291487 describes a similar apparatus in which gas supply ports direct cooled inert gas to the material exiting from the nozzle.

### SUMMARY OF THE PRESENT INVENTION

However, there is still a limitation in using the µ pulling-down method to grow a good single crystal plate (a planar body of a single crystal) continuously at a high rate.

The present inventors tried to form a shoulder portion by adjusting the temperature of the melt, the ambient temperature around a fiber, etc. when an oxide single crystal fiber (seed crystal) was firstly contacted to a melt and then the melt was pulled down. The width of the shoulder portion is gradually enlarged, and when it reaches the desired size, temperatures of such as a nozzle portion are slightly raised to stop the increase in width of the shoulder portion. After that, a planar body having a uniform width is continuously pulled down following a terminal end of the shoulder portion. According to this method, cracks are hard to progress from near a joint interface of the seed crystal and the planar body.

However, during further examination of this method, the following problems arouse. That is, in order to grow an oxide single crystal with the p pulling-down method, a temperature gradient is formed immediately under an opening of a crucible by making a temperature of an anneal region lower than that of the crucible at the opening. The temperature of the anneal region is controlled to a constant value by using an after-heater and a lower furnace. However, when a fibrous single crystal was used, cracks might occur in a case of a planar single crystal lengthwise (perpendicularly) even under such condition that could grow an oxide single crystal well.

It is an object of the present invention to stably grow a planar body of an oxide single crystal having good crystallinity and to prevent cracks in the crystal, when the oxide single crystal is grown with the p pulling-down method.

The present invention provides a process for producing an oxide single crystal, as set out in claim 1.

The present invention also relates to an apparatus for producing an oxide single crystal, as set out in claim 6.

The present inventors had examined various methods to prevent the above cracks extending perpendicularly in the crystal. The present inventors firstly investigated the cause of occurring the cracks lengthwise, and found that a dimensional change occurred in the planar single crystal. That is, the width of the planar single crystal near the opening of the crucible was larger than that in an anneal region apart downwardly from that opening by, for example, about 0.5%. This was caused by a thermal expansion of the oxide single crystal. It is more likely that such dimensional change in the width of the planar single crystal generates a thermal stress in the crystal, thus causes the cracks extending in perpendicularly.

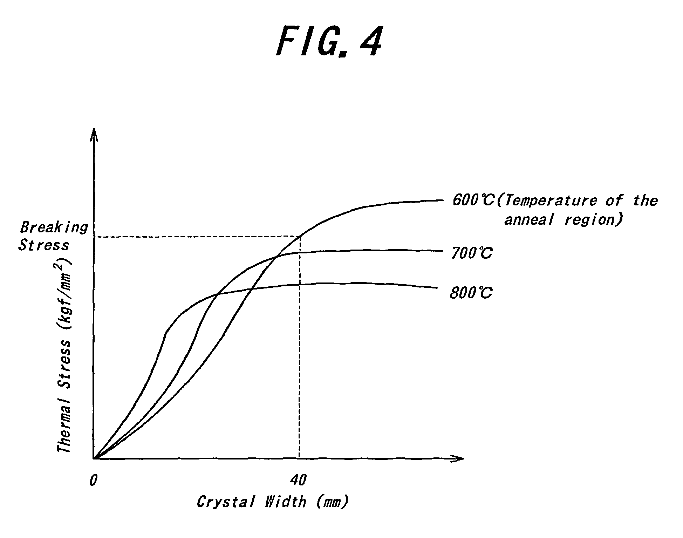

The present inventors calculated the magnitude of the thermal stress generated in the crystal with the finite element method, when the temperature of the anneal region was changed. The result is shown in FIG. 4. It was then found that the thermal stress was increased as the width of the crystal became larger, and finally had nearly a constant value. It was also found that the final thermal stress became larger when the temperature of the anneal region was low.

For this reason, the present inventors tried to reduce the thermal stress generated in the planar single crystal by increasing an input electric power to an after-heater to raise the temperature of the anneal region by, for example, about 100°C. However, in this case, as a degree of supercooling of the melt drawn from the opening of the crucible was insufficient, a solid phase-liquid phase interface was descended, the width of the crystal was fluctuated, and problems such as deterioration in crystallinity of the single crystal or heterogeneous composition of the crystal arose. Moreover, it was impossible to enlarge the width of the planar single crystal beyond a certain size. The reason for this was that the temperature gradient near the opening of the crucible became smaller since a difference in temperature between the region near the opening of the crucible and the anneal region decreased.

For this reason, the present inventors conceived to provide a cooler at least under the opening of the crucible and to cool the oxide single crystal with the cooler while it is drawn from the opening of the crucible. This makes it possible that a sufficiently large temperature gradient is generated in a region immediately under the opening of the crucible to grow the single crystal having a good quality, even if the temperature difference between the region near the opening of the crucible and the anneal region is decreased to such an extent that no cracks occurs in the single crystal.

The present invention primarily relates to a planar single crystal. However, as for fibrous single crystals, since cracks occur in some single crystals to cause a yield loss, the present invention is also effective to prevent these cracks.

From a viewpoint of preventing cracks in the oxide single crystal, the temperature difference of the oxide single crystal between at the opening of the crucible and at the anneal region is preferably 300°C or less, and more preferably 200°C or less.

Particularly preferably, the temperature gradient within a distance of 1mm from the opening of the crucible is 100°C/mm or more, and more preferably 150°C/mm or more.

A cooler is provided at least under the opening of the crucible, and further cooler(s) may be provided around the opening and/or surrounding the nozzle portion.

In a preferred embodiment of the present invention, the cooler has path for flowing a cooling medium and the cooling medium remove the ambient heat around the cooler.

In another preferred embodiment of the present invention, the cooler has a blowing hole for blowing out the cooling medium toward the oxide single crystal. Thus, a cooling efficiency is further improved.

The cooling medium may be either a gas or a liquid. Air, nitrogen, helium or the like may be recited as an example of a gaseous cooling medium. A temperature of the gas is preferably lower by at least 500°C than that of the anneal region controlled by an after-heater and a lower furnace. Moreover, a liquid may be used as a cooling medium. In this case, using a mist may improve the cooling efficiency and eliminate a possibility of a steam explosion.

In a preferred embodiment of the present invention, the crucible has a nozzle portion, and an opening is provided at a tip of the nozzle portion. The raw material is melted in the crucible, and then a melt of the raw material is drawn from the opening to grow the oxide single crystal.

### BRIEF DESCRIPTION OF THE DRAWINGS

The present invention will be further explained in detail hereinafter with reference to the accompanying drawings, in which:
FIG. 1 is a schematic sectional view showing an embodiment of a producing apparatus for growing a single crystal;
FIG. 2(a) and FIG. 2(b) are both schematic sectional views outlining a region surrounding the opening 13c of the nozzle portion 13;
FIG. 3 is a graph showing changes in the temperature gradient of producing apparatus of each of Invention Example 1, Comparative Example 1 and Comparative Example 2 of the present invention in a region immediately under the opening of the nozzle portion; and
FIG. 4 is a graphical representation showing a results obtained by calculating the magnitude of the thermal stress generated in the crystal using the finite element method, when the temperature of the anneal region is changed.

### DESCRIPTION OF THE PREFERRED EMBODIMENT

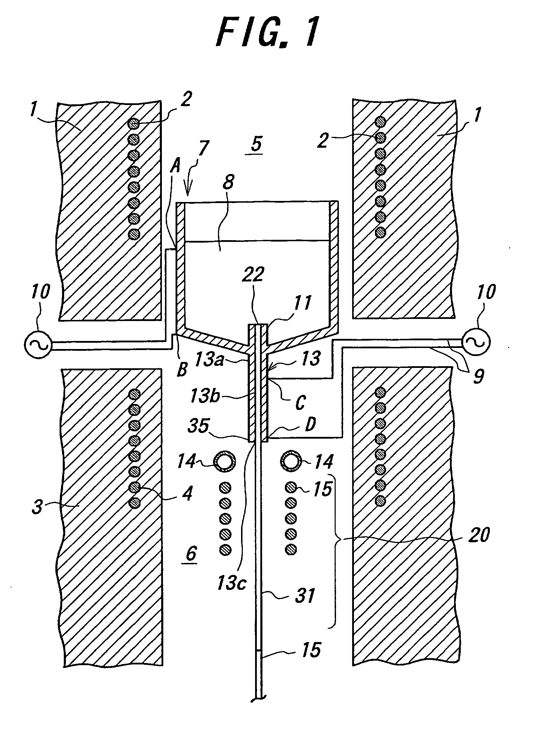

A crucible 7 is placed in a furnace body. An upper furnace unit 1 is arranged to surround the crucible 7 and an upper space 5 thereof, and has a heater 2 buried therein. A nozzle portion 13 extends downwardly from a bottom part of the crucible 7. The nozzle portion 13 comprises a connecting-tube portion 13a and a planar expanded portion 13b at the lower end of the connecting-tube portion 13a. In FIG.1, only a cross sectional view of the planar expanded portion 13b is shown. The connecting-tube portion 13a and the planar expanded portion 13b can be changed variously in shape.

A slender opening 13c is formed at the lower end of the planar expanded portion 13b, and a region near the opening 13c is a single crystal-growing portion 35. A lower furnace unit 3 is arranged to surround the nozzle portion 13 and a surrounding space 6 thereof, and has a heater 4 buried therein. An intake tube 11 extends upwardly in the crucible 7 and an intake opening 22 is provided at the upper end of the intake tube 11. The intake opening 22 slightly protrudes from a bottom portion of a melt 8. The crucible 7 and the nozzle 13 are both formed from a corrosion-resistant conductive material.

One electrode of a power source 10 is connected to a point A of the crucible 7 with an electric wire 9, and the other electrode of the power source 10 is connected to a lower bent B of the crucible 7. One electrode of another power source 10 is connected to a point C of the connecting-tube portion 13a with an electric wire 9, and the other electrode of the power source 10 is connected to a lower end D of the planar expanded portion 13b. These current-carrying systems are isolated from each other and configured to control their voltages independently.

A cooler 14 is provided adjacent to an oxide single crystal 31 immediately under the opening 13c of the nozzle portion 13, and an after-heater 15 is provided under the cooler 14. The after-heater 15 is provided in an anneal region 20.

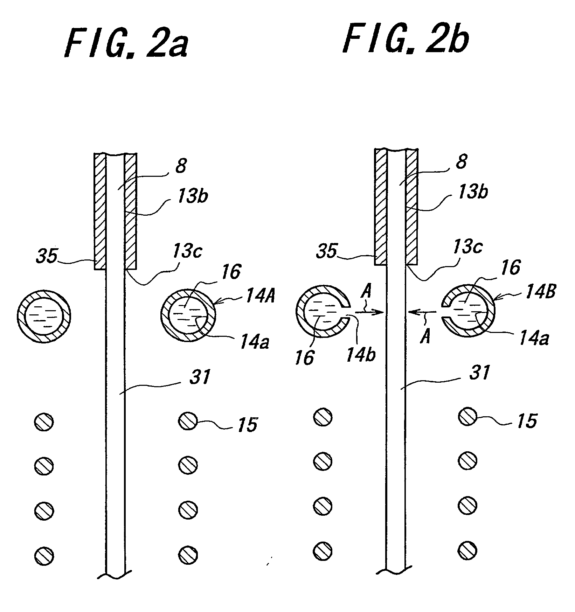

In FIG. 2(a), the cooler comprises a cooling tube 14A, and a cooling medium 16 flows through an internal portion 14a of the cooling tube 14A. In FIG. 2(b), the cooler comprises a cooling tube 14B, and the cooling medium 16 flows through an internal portion 14a of the cooling tube 14B. Blowing holes 14b are formed in the cooling tube 14B to be faced with the oxide single crystal 31 so that the cooling medium in the tube is blown out through the blowing holes 14b toward the oxide single crystal 31 as arrows A indicate.

The temperature distribution in each of the space 5 and 6 is set appropriately by generating heat from the upper furnace unit 1, the lower furnace unit 3 and the after-heater 15, and by operating the cooler 14. Then a raw material for the melt is supplied into the crucible 7 and the electricity is supplied to the crucible 7 and the nozzle portion 13 for heating. In this condition, the melt slightly protrudes from the opening 13c at the single crystal-growing portion 35.

The cooler is not limited to the tubular form, but, for example, a planar form may be used. Moreover, a cooling effect of the cooler is not limited to a heat exchange with the cooling medium flowing through the cooling tube, but cooling with a gas expansion or electrical cooling in such as a thermoelectric conversion element may be used.

An oxide single crystal is not particularly limited, but, for example, lithium potassium niobate (KLN), lithium potassium niobate-lithium potassium tantalate solid solution (KLTN : [K₃Li₂₋ₓ(Ta_{y}Nb_{1-y})₅₊ₓO₁₅₊₂ₓ]), lithium niobate, lithium tantalate, lithium niobate-lithium tantalate solid solution, Ba₁₋ₓSrₓNb₂O₆, Mn-Zn ferrite, yttrium aluminum garnet substituted with Nd, Er and/or Yb, YAG, and YVO₄ substituted with Nd, Er, and/or Yb can be exemplified.

### Example 1

With a single crystal-producing apparatus shown in FIG. 1, a planar body of a lithium potassium niobate single crystal was produced according to the invention. A cooling tube 14A shown in FIG. 2(a) was used. The outer and inner diameters of the cooling tube are 6mm and 4mm, respectively, and air was fed into the cooling tube.

The temperature of the whole furnace was controlled by the upper furnace unit 1 and the lower furnace unit 3. The apparatus was configured to be able to control the temperature gradient near the single crystal-growing portion 35 by controlling an electric supply to the nozzle portion 13, heat generation of the after-heater 12 and a flow rate of air in the cooling tube 14A. A mechanism of pulling down the single crystal plate was equipped, in which a single crystal plate was pulled down with the pulling-down rate controlled uniformly within a range from 2 to 100 mm/hour in a vertical direction.

A fibrous seed crystal of lithium potassium niobate was used. A dimension of the seed crystal was 1mm x 1mm in cross-section and 15 mm in length. The seed crystal was bonded to a holding rod with a heat-resistance inorganic adhesive, and the holding rod was connected to the pulling-down mechanism (not shown).

The crucible 7 had an elliptical cross-sectional planar shape, wherein the major axis, the minor axis and the height was 70mm, 10mm and 10mm, respectively. The length of the connecting-tube portion was 5mm. A cross-sectional dimension of the planar expanded portion 13b was 1mm x 70mm. A dimension of the opening 13c was 1mm long x 70mm wide.

Potassium carbonate, lithium carbonate and niobium pentoxide were prepared at a molar ratio of 30 : 25 : 45 to produce a raw material powder. The raw material powder was supplied into the platinum crucible 7, and the crucible 7 was set in place. With controlling the temperature of the space 5 in the upper furnace unit 1 within a range from 1100 to 1200°C, the raw material in the crucible 7 was melted. The temperature of the anneal region 20 in the lower furnace unit 3 was controlled uniformly at 700°C. While a given electric power was supplied to each of the crucible 7, the nozzle portion 13 and the after-heater 15 and air was supplied at 50 liter/minute to the cooling tube 14A, a single crystal was grown. In this case, the temperature of the single crystal-growing portion 35 could be about 1000°C. The temperature gradient under the opening 13c could be controlled at 150°C/mm within the range of 1mm from the opening 13c of the nozzle portion 13, at 25°C/mm in average within the range of 1-5 mm, and at 1 °C/mm within the range of 5-30mm.

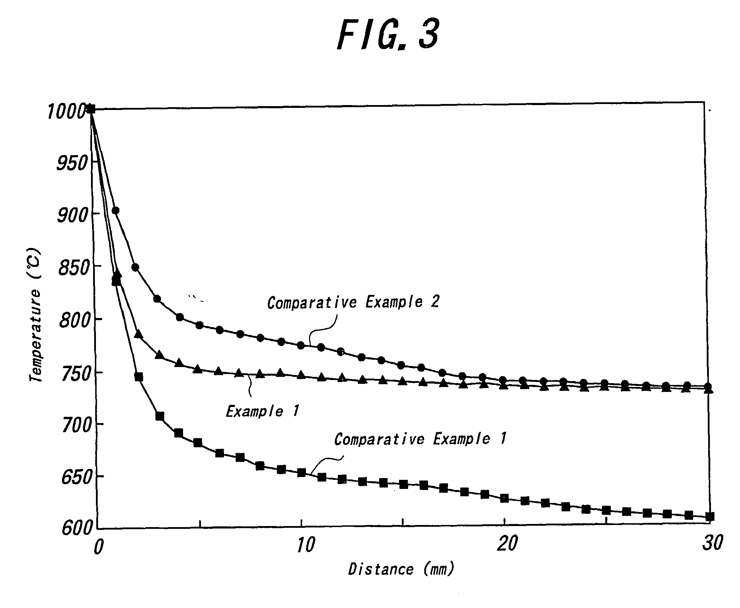

A relationship between a distance from the tip of the nozzle and a temperature in this case is shown in FIG.3 (Example 1).

Under such conditions, the seed crystal 15 was pulled down at a rate of 10mm/h. As a result, a lower portion of a melt band was gradually crystallized to form a shoulder portion. When the seed crystal was further lowered, an area of the shoulder portion gradually increased. At this time, the width of the planar body 31 was controlled at 50mm by suppressing the enlargement of the width of the shoulder portion through controlling the temperature of the nozzle portion 13.

While the raw material in equal weight to that of the crystallized melt was fed to the crucible 7, the crystal was kept growing until the total length of the shoulder portion and the planar body reached 100mm, then the planar body was cut off from the nozzle portion 13 and was annealed.

The lattice constant of the shoulder portion of the obtained planar body was measured to give the a-axis length of 12.57Å and the c-axis length of 4.03Å. A molar ratio of potassium, lithium and niobium was 30:18:52, respectively. A half width of an X-ray rocking curve was 50 seconds. No crack occurred during growing and annealing of the crystal.

### Example 2

A planar body was grown according to Example 1 except that a cooling tube 14B shown in FIG. 2(b) was used. The outer and the inner diameters of the cooling tube 14B were 6mm and 4mm, respectively. The diameter of a blowing hole 14b was 1mm. Air was fed into the cooling tube 14B at a flow rate of 10 liter/minute. As a result, a temperature gradient similar to that in Example 1 was obtained. Also, the lattice constant, the composition ratio and the half width of the obtained planar body were almost the same as in the planar body of Example 1. Moreover, no crack occurred during growing of the crystal and annealing.

### Comparative Example 1

A planar body was grown according to Example 1 except that a cooler was not installed. The temperature of the upper space 5 in the upper furnace unit 1 was controlled within a range of 1100-1200°C, and the temperature of the anneal region 20 in the lower furnace unit 3 was controlled uniformly at 600°C. While a given electric power was supplied to each of the crucible 7, the nozzle portion 13 and the after-heater 15, a single crystal was grown. In this case, the temperature of the single crystal-growing portion 35 could be about 1000°C. The temperature gradient under the opening 13c could be controlled at 150°C/mm within the range of 1mm from the opening 13c of the nozzle portion 13, at 40°C/mm in average within the range of 1-5 mm, and at 6°C/mm within the range of 5-30mm. A relationship between a distance from the tip of the nozzle and a temperature in this case is shown in FIG.3 (Comparative Example 1).

A crystal was grown according to Example 1, and a crack occurred near the center of the crystal in a vertical direction when the width of the shoulder portion reached 40mm.

### Comparative Example 2

A planar body was grown according to Example 1 except that a cooler was not installed. The temperature of the upper space 5 in the upper furnace unit 1 was controlled within a range of 1100-1200°C, and the temperature of the anneal region 20 in the lower furnace unit 3 was controlled uniformly at 700°C. While a given electric power was supplied to each of the crucible 7, the nozzle portion 13 and the after-heater 15, a single crystal was grown. In this case, the temperature of the single crystal-growing portion 35 could be about 1000°C. The temperature gradient under the opening 13c could be controlled at 90°C/mm within the range of 1mm from the opening 13c of the nozzle portion 13, at 25°C/mm in average within the range of 1-5 mm, and at 3°C/mm within the range of 5-30mm. A relationship between a distance from the tip of the nozzle and a temperature in this case is shown in FIG.3 (Comparative Example 2).

When a crystal was grown according to Example 1, the degree of the supercooling was not sufficient since the temperature gradient in the single crystal-growing portion was small, thus the width of the crystal did not increase beyond 20mm. Also, the solid phase-liquid phase interface was descended, and the width of crystal was fluctuated. Many striations could be found in the obtained planar body, and a half width of the obtained planar body was 70 seconds.

As mentioned above, according to the invention, when the planar body of the oxide single crystal was grown by the p pulling-down method, cracks can be prevented and the planar body with good crystallinity can be grown continuously and stably.

## Claims

1. A process for producing an oxide single crystal (31), said process comprising the steps of melting a raw material of said oxide single crystal in a crucible (7), contacting a seed crystal (15) to the melt of the raw material, drawing said melt from an opening (13c) of said crucible by pulling down the seed crystal (15), growing the oxide single crystal (31), and cooling said oxide single crystal (31) by means of a cooler (14) while it is being drawn from said opening (13c) of said crucible, **characterised by** controlling the temperature of the single oxide crystal by means of an after-heater (15) provided downstream from the cooler (14) in the movement direction of the crystal.

2. A process for producing an oxide single crystal according to claim 1, wherein said oxide single crystal (31) is cooled by said cooler (14) by removing ambient heat thereof.

3. A process for producing an oxide single crystal according to claim 1 or 2, wherein said oxide single crystal is cooled by said cooler (14) blowing a cooling medium thereto.

4. A process for producing an oxide single crystal according to any one of claims 1 to 3, wherein said oxide single crystal is drawn from an opening (13c) of a nozzle portion (13b) provided at a tip of said crucible (7).

5. A process for producing an oxide single crystal according to any one of claims 1 to 5, wherein said oxide single crystal (31) is of a planar form.

6. An apparatus for producing an oxide single crystal (31) comprising a crucible (7) for melting a raw material of said oxide single crystal and a cooler (14), wherein said crucible has an opening (13c) and said cooler is provided at least under said opening (13c) of the crucible (7) to cool said oxide single crystal, while it is drawn from said opening of the crucible, **characterised in that** said apparatus further includes an after-heater (15) arranged for controlling the temperature of the single oxide crystal downstream from the cooler (14) in the movement direction of the crystal.

7. An apparatus for producing an oxide single crystal according to claim 6, wherein said cooler (14) is provided with path (14A) for flowing a cooling medium to remove ambient heat of the cooler.

8. An apparatus for producing an oxide single crystal according to claim 6 or 7, wherein the cooler (14) has a blowing hole (14c) for blowing out a cooling medium toward said oxide single crystal (31).

9. An apparatus for producing an oxide single crystal according to any one of claims 6 to 8, wherein said crucible (7) has a nozzle portion (13b) and said opening (13c) is provided at a tip of said nozzle portion (13b).

10. An apparatus for producing an oxide single crystal according to any one of claims 6 to 9, wherein opening is shaped to produce said oxide single crystal in a planar form.

## Patentansprüche

1. Verfahren zur Herstellung eines Oxid-Einkristalls (31), umfassend die folgenden Schritte:
das Schmelzen eines Rohmaterials des Oxid-Einkristalls in einem Schmelztiegel (7), das In-Berührung-Bringen eines Keimkristalls (15) mit der Rohmaterialschmelze, das Ziehen der Schmelze aus einer Öffnung (13c) des Schmelztiegels durch Nach-unten-Ziehen des Keimkristalls (15), das Wachsenlassen des Oxid-Einkristalls (31) und Abkühlen des Oxid-Einkristalls (31) mit einer Kühlvorrichtung (14) während er aus der Öffnung (13c) des Schmelztiegels gezogen wird,
**dadurch gekennzeichnet, dass**
die Temperatur des Oxid-Einkristalls mittels einer Nachwärmevorrichtung (15), die stromabwärts der Kühlvorrichtung (14) in Bewegungsrichtung des Kristalls bereitgestellt ist, gesteuert wird.

2. Verfahren zur Herstellung eines Oxid-Einkristalls nach Anspruch 1, worin der Oxid-Einkristall (31) mit der Kühlvorrichtung (14) durch Entziehung von Umgebungswärme aus dieser abgekühlt wird.

3. Verfahren zur Herstellung eines Oxid-Einkristalls nach Anspruch 1 oder 2, worin der Oxid-Einkristall mit der Kühlvorrichtung (14) durch Blasen eines Kühlmediums auf diesen abgekühlt wird.

4. Verfahren zur Herstellung eines Oxid-Einkristalls nach einem der Ansprüche 1 bis 3, worin der Oxid-Einkristall aus einer Öffnung (13c) eines Düsenabschnitts (13b), der an einer Spitze des Schmelztiegels (7) bereitgestellt ist, gezogen wird.

5. Verfahren zur Herstellung eines Oxid-Einkristalls nach einem der Ansprüche 1 bis 5, worin der Oxid-Einkristall (31) eine planare Form aufweist.

6. Vorrichtung zur Herstellung eines Oxid-Einkristalls (31), umfassend einen Schmelztiegel (7) zum Schmelzen eines Rohmaterials des Oxid-Einkristalls und eine Kühlvorrichtung (14), worin der Schmelztiegel eine Öffnung (13c) aufweist und die Kühlvorrichtung zumindest unterhalb der Öffnung (13c) des Schmelztiegels (7) bereitgestellt ist, um den Oxid-Einkristall abzukühlen, während er aus der Öffnung des Schmelztiegels gezogen wird,
**dadurch gekennzeichnet, dass**
die Vorrichtung ferner eine Nachwärmevorrichtung (15) umfasst, die angeordnet ist, um die Temperatur des Oxid-Einkristalls stromabwärts der Kühlvorrichtung (14) in Bewegungsrichtung des Kristalls zu steuern.

7. Vorrichtung zur Herstellung eines Oxid-Einkristalls nach Anspruch 6, worin die Kühlvorrichtung (14) mit einem Weg (14A) bereitgestellt ist, um ein Kühlmedium durchströmen zu lassen, damit der Kühlvorrichtung Umgebungswärme entzogen wird.

8. Vorrichtung zur Herstellung eines Oxid-Einkristalls nach Anspruch 6 oder 7, worin die Kühlvorrichtung (14) ein Blasloch (14c) zum Ausblasen eines Kühlmediums in Richtung des Oxid-Einkristalls (31) aufweist.

9. Vorrichtung zur Herstellung eines Oxid-Einkristalls nach einem der Ansprüche 6 bis 8, worin der Schmelztiegel (7) einen Düsenabschnitt (13b) aufweist und die Öffnung (13c) an einer Spitze des Düsenabschnitts (13b) bereitgestellt ist.

10. Vorrichtung zur Herstellung eines Oxid-Einkristalls nach einem der Ansprüche 6 bis 9, worin die Öffnung so geformt ist, dass sie den Oxid-Einkristall in planarer Form erzeugt.

## Revendications

1. Procédé pour produire un monocristal d'oxyde (31), ledit procédé comprenant les étapes consistant à faire fondre un matériau brut dudit monocristal d'oxyde dans un creuset (7), à mettre en contact le germe cristallin (15) avec la fusion de matériau brut, à retirer ladite fusion d'une ouverture (13c) dudit creuset en tirant vers le bas le germe cristallin (15), à faire croître le monocristal d'oxyde (31) et à refroidir ledit monocristal d'oxyde (31) par un organe de refroidissement (14) pendant qu'il est retiré de ladite ouverture (13c) dudit creuset, **caractérisé par** le réglage de la température du monocristal d'oxyde au moyen d'un organe de chauffage (15) réalisé en aval de l'organe de refroidissement (14) dans la direction de déplacement du cristal.

2. Procédé pour la production d'un monocristal d'oxyde selon la revendication 1, où ledit monocristal d'oxyde (31) est refroidi par ledit organe de refroidissement (14) en retirant sa chaleur ambiante.

3. Procédé pour la production d'un monocristal d'oxyde selon la revendication 1 ou 2, où ledit monocristal d'oxyde est refroidi par ledit organe de refroidissement (14) soufflant un milieu de refroidissement sur celui-ci.

4. Procédé pour la production d'un monocristal d'oxyde selon l'une des revendications 1 à 3, où ledit monocristal d'oxyde est retiré d'une ouverture (13c) d'une portion de buse (13b) réalisée à une pointe dudit creuset (7).

5. Procédé pour la production d'un monocristal d'oxyde selon l'une des revendications 1 à 5, où ledit monocristal d'oxyde (31) a une forme plane.

6. Appareil pour la production d'un monocristal d'oxyde (31) comprenant un creuset (7) pour faire fondre un matériau brut dudit monocristal d'oxyde et un organe de refroidissement (14), où ledit creuset présente une ouverture (13c), et ledit organe de refroidissement est prévu au moins sous ladite ouverture (13c) du creuset (7) pour refroidir ledit monocristal d'oxyde pendant qu'il est retiré de ladite ouverture du creuset, **caractérisé en ce que** ledit appareil comprend en outre un organe de chauffage (15) agencé pour régler la température du monocristal d'oxyde en aval de l'organe de refroidissement (14) dans la direction de déplacement du cristal.

7. Appareil pour la production d'un monocristal d'oxyde selon la revendication 6, où ledit organe de refroidissement (14) présente un chemin (14A) pour l'écoulement d'un milieu de refroidissement afin de retirer la chaleur ambiante de l'organe de refroidissement.

8. Appareil pour la production d'un monocristal d'oxyde selon la revendication 6 ou 7, où l'organe de refroidissement (14) présente un trou de soufflage (14c) pour souffler un milieu de refroidissement vers ledit monocristal d'oxyde (31).

9. Appareil pour la production d'un monocristal d'oxyde selon l'une des revendications 6 à 8, où ledit creuset (7) possède une portion de buse (13b), et ladite ouverture (13c) est réalisée à une pointe de ladite portion de buse (13b).

10. Appareil pour la production d'un monocristal d'oxyde selon l'une des revendications 6 à 9, où l'ouverture est configurée pour produire ledit monocristal d'oxyde en une forme plane.
